(19) Europäisches Patentamt
European Patent Office
Office européen des brevets

(11) **EP 2 876 691 A1**

(12) **EUROPEAN PATENT APPLICATION**

(43) Date of publication:
**27.05.2015 Bulletin 2015/22**

(51) Int Cl.:
***H01L 31/046*** (2014.01)

(21) Application number: **14187983.3**

(22) Date of filing: **07.10.2014**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br><br>(30) Priority: **20.11.2013  KR 20130141706** | (71) Applicant: **Samsung SDI Co., Ltd.**<br>**Yongin-si, Gyeonggi-do (KR)**<br><br>(72) Inventor: **Kim, Dong-Jin**<br>**Gyeonggi-do (KR)**<br><br>(74) Representative: **Walaski, Jan Filip et al**<br>**Venner Shipley LLP**<br>**200 Aldersgate**<br>**London EC1A 4HD (GB)** |

(54) **Solar cell array**

(57) A solar cell array includes: a substrate; a plurality of first electrodes on the substrate and separated from each other; a photoactive layer on each of the first electrodes; and a second electrode on each of the photoactive layers. The photoactive layer includes a gap exposing a neighbouring one of the first electrodes. The second electrode is electrically coupled to the neighbouring one of the first electrodes at the gap. At least two of the plurality of first electrodes have sizes different from each other.

## FIG. 1

**Description**

The present invention relates to a solar cell array.

A solar cell array includes a photovoltaic element that converts solar energy to electrical energy, and the solar cell array is gaining interest as an unlimited and non-polluting next generation energy source.

A solar cell array includes a p-type semiconductor and an n-type semiconductor, and when solar energy is absorbed by a photoactive layer, electron-hole pairs (EHPs) are generated in the semiconductor. Then, the generated electrons and holes move to the n-type semiconductor and the p-type semiconductor, respectively, and are collected by electrodes, and can then be used as electrical energy.

The photoactive layer may include a compound semiconductor including group I-III-VI elements. The compound semiconductor may realize a high efficiency solar cell array with a high light absorption coefficient and high optical stability.

Such a solar cell array is formed of unit cells that are substantially equal in size and electrically coupled (e.g., electrically connected) to each other on a substrate. In this case, the unit cells may be formed as a continuous thin film on the substrate and then separated from each other through a scribing process. When one or more characteristics or properties of the thin film vary depending on a location on the substrate, a current generated in each unit cell may be different.

When the current generated in each of the unit cells is different, the current generated in each of the unit cells is lowered to the minimum or lowest current generated in one of the unit cells.

Aspects of the present invention are directed toward a solar cell array including a CIGS semiconductor. Aspects of the present invention are also directed toward a solar cell array having unit cells respectively generating substantially the same amount of current regardless of a characteristic of a thin film.

A solar cell array according to an example embodiment includes: a substrate; a plurality of first electrodes on the substrate and separated from each other; a photoactive layer on each of the first electrodes, the photoactive layer having a gap exposing a neighbouring one of the first electrodes; and a second electrode on each of the photoactive layers, the second electrode being electrically coupled to the neighbouring one of the first electrodes at the gap, wherein at least two of the plurality of first electrodes have sizes different from each other.

A difference between respective areas of the at least two first electrodes may be within about 3%.

Each of the plurality of first electrodes may have a rectangular shape having a pair of short sides extending in a direction that crosses the gap (e.g., substantially perpendicular to a direction in which the gap extends), and lengths of the short sides of the respective first electrodes may be different from each other.

The length of each of the short sides of each of the plurality of first electrodes may be in a range of about 3.5 mm to about 6 mm.

The second electrodes may have thicknesses that are different from each other.

A thickness of a second electrode on one of the first electrodes having a relatively large area may be less than a thickness of a second electrode on another of the first electrodes having a relatively small area.

A solar cell array according to another example embodiment includes: a substrate; a plurality of first electrodes on the substrate and separated from each other; a photoactive layer on each of the first electrodes, the photoactive layer having a gap exposing a neighbouring one of the first electrodes; and a second electrode on each of the photoactive layers, the second electrode being electrically coupled to the neighbouring one of the electrodes at the gap. At least two of the second electrodes have thicknesses that are different from each other.

A difference between thicknesses of the at least two second electrodes may be within about 3%, and the thickness of each second electrode may be in a range of about 0.9 $\mu$m to about 1.25 $\mu$m.

Each of the first electrodes may include an opaque metal, and the second electrode may include a transparent conductive material.

Each photoactive layer may include a CIGS-based material.

A solar cell array according to another example embodiment includes a substrate and a plurality of solar cells on the substrate and electrically coupled to each other. First electrodes of at least two solar cells from among the plurality of solar cells may have areas different in size from each other, and the plurality of solar cells may have substantially the same short-circuit current as each other.

The first electrode may have a rectangular shape, and a length of each of a pair of shorter sides among sides of the first electrode may be in a range of about 3.5 mm to about 6 mm.

A solar cell array according to another example embodiment includes a substrate, and a plurality of solar cells on the substrate and electrically coupled to each other. Second electrodes of at least two of the solar cells from among the plurality of solar cells have thicknesses different from each other, and short-circuit currents of the solar cells may be substantially the same as (e.g., substantially equivalent to) each other.

The thickness of each of the second electrodes may be in a range of about 0.9 $\mu$m to about 1.25 $\mu$m.

According to a further aspect of the invention, there is provided a method of manufacturing a solar cell array that comprises a plurality of solar cells, each of the solar cells comprising a first electrode, a photoactive layer on the first electrode extending to the first electrode of the neighbouring solar cell, the photoactive layer having a gap exposing the first electrode of the neighbouring solar cell, and a second electrode on the photoactive layer, the second electrode being electrically connected to the first electrode of the neighbouring solar cell at the gap, the method comprising varying the size of the first electrodes and/or the thickness of the second electrodes of one or more of the solar cells so that the currents generated in each of the solar cells are substantially the same as one another.

The method may comprise varying the size of the first electrodes and/or the thickness of the second electrodes based on information about currents generated by cells at a predetermined location on the substrate.

The method may comprise fabricating a first solar cell array on a first substrate, determining currents generated by solar cells in the first solar array, adjusting the fabrication process to vary the the size of the first electrodes and/or the thickness of the second electrodes to be fabricated as a second solar cell array on a second substrate and fabricating the second solar cell array on the second substrate using the adjusted fabrication process.

According to aspects of the example embodiments, the current generated in the respective unit cells may be substantially the same or the same (e.g., substantially uniform) regardless of a characteristic of a thin film used to form a solar cell array, thereby increasing efficiency of the solar cell array.

Embodiments of the invention will now be described by way of example with reference to the accompanying drawings, in which:

> FIG. 1 is a schematic top plan view of a solar cell array according to an example embodiment.
> FIG. 2 is a cross-sectional view of FIG. 1, taken along the line II-II.
> FIG. 3 is a schematic top plan view of a solar cell array according to another example embodiment.
> FIG. 4 is a schematic top plan view of a comparative solar cell array.

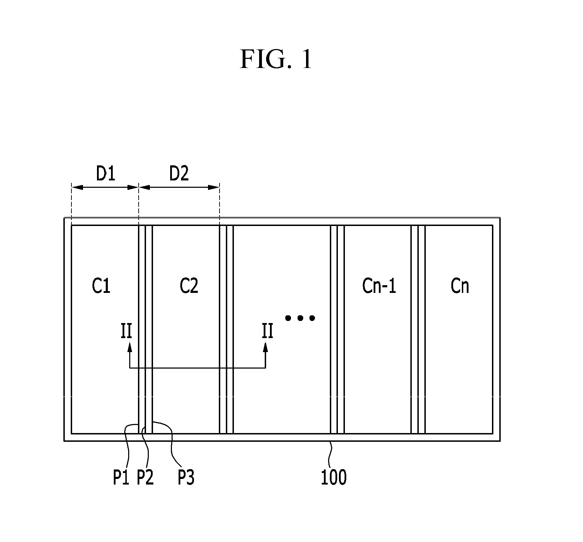

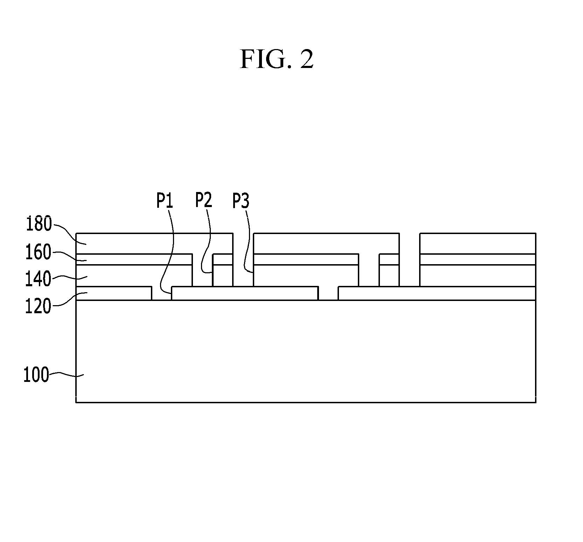

As shown in FIG. 1 and FIG. 2, a solar cell array according to an example embodiment includes a plurality of solar cells C1 to Cn formed on a substrate 100.

Each solar cell includes a first electrode 120, a photoactive layer 140 formed on the first electrode 120, a buffer layer 160 formed on the photoactive layer 140, and a second electrode 180 formed on the buffer layer 160, and neighbouring cells (e.g., adjacent cells) are electrically coupled (e.g., electrically connected) to each other.

The first electrodes 120 of adjacent cells are arranged with a substantially constant gap P1 therebetween. In some embodiments, a width of the gap P1 may be in a range of about 20 $\mu$m to about 100 $\mu$m.

The first electrode 120 may have a rectangular shape of which long sides are parallel with (e.g., extend parallel to) the gap P1, and at least two of the first electrodes 120 may have sizes different from each other. In this case, sides that are parallel with the gap P1 from among sides of each first electrode 120 (e.g., the long sides of each first electrode 120) have substantially the same length, and lengths D1 and D2 (hereinafter referred to as widths of the first electrodes 120) of short sides from among sides of each first electrode 120 that are perpendicular to the gap P1 (e.g., that extend substantially perpendicular to the long sides of each first electrode 120) may be different from each other.

The width of the first electrode 120 may be in a range from about 3.5 mm to about 6 mm.

In FIG. 1, the width D1 of the first electrode 120 of the first cell C1 and the width D2 of the first electrode 120 of the second cell C2 are different from each other, but the width of first electrodes 120 of cells that are located at a distance from each other (e.g., cells that are not directly adjacent to each other) may also be different from each other, for example, the first cell C1 and the third cell C3 and/or the second cell C2 and an n-th cell Cn.

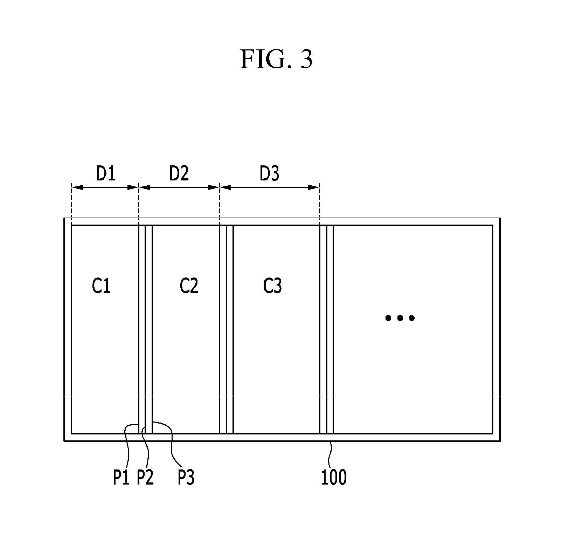

In addition, as shown in FIG. 3, the number of first electrodes 120 respectively having widths D1, D2, and D3 different from each other may be three or more, and such cells may be sequentially arranged or randomly arranged.

As described, a deviation of currents generated in each of the solar cells can be prevented or reduced by differentiating or varying the widths of the respective first electrodes.

That is, when the respective first electrodes have substantially the same size and the amount of current generated in the first cell C1 is greater than the amount of current generated in the second cell C2, the current generated in the first and second cells C1 and C2 can be made to be substantially the same or the same (e.g., can become equivalent to each other) by reducing the width D1 of the first electrode 120 of the first cell C1 or by increasing the width D2 of the first electrode 120 of the second cell C2. The amount of current generated in each cell may be affected by (e.g., changed or varied according to) a temperature and/or a deposition condition of a process that forms the photoactive layer in each cell. However, because the same act (process) is iteratively performed on each substrate, the amount of current generated in a respective cell may tend to be consistent according to the location on the substrate. Therefore, widths of first electrodes of cells formed on a subsequent (e.g., next) substrate are made to be different from each other with reference to (according to) the amount of current generated in the respective cells formed on the previous substrate.

Referring back to FIG. 1 and FIG. 2, the substrate 100 may be made of an insulating transparent material, for example, soda-lime glass.

The first electrode 120 may be made of a metal having an excellent heat resistive characteristic, an excellent electrical contact characteristic with respect to a material that forms the photoactive layer 140, excellent electric conductivity, and excellent interface adherence with the substrate 100. For example, the first electrode 120 may be made of molybdenum (Mo).

The photoactive layer 140 and the buffer layer 160 are formed on the first electrode 120. The photoactive layer 140 fills the gap P1 between neighbouring (e.g., adjacent) first electrodes 120.

As a p-type CIS semiconductor, the photoactive layer 140 may include selenium (Se) and/or sulfur (S). For example, the photoactive layer 140 may include $Cu(In_{1-x},Ga_x)(Se_{1-x},S_x)$ as a group I-III-VI-based semiconductor compound and may be a compound semiconductor having a composition of $0 \leq x \leq 1$. The photoactive layer 140 may have a single phase of which a composition in the compound semiconductor is substantially uniform. For example, the photoactive layer 140 may be $CuInSe_2$, $CuInS_2$, $Cu(In,Ga)Se_2$, $(Ag,Cu)(In,Ga)Se_2$, $(Ag,Cu)(In,Ga)(Se,S)_2$, $Cu(In,Ga)(Se,S)_2$, or $Cu(In,Ga)S_2$. In addition, the photoactive layer 140 may include sodium (Na), which is diffused from the substrate 100.

The buffer layer 160 reduces an energy gap difference between the photoactive layer 140 and the second electrode 180. The buffer layer 160 may be made of an n-type semiconductor material having high light transmittance, for example, cadmium sulfide (CdS), zinc sulfide (ZnS), or indium sulfide (InS).

The buffer layer 160 and the photoactive layer 140 include a gap (e.g., an opening or through-hole) P2 that exposes the first electrode 120 (e.g., exposes a portion of the first electrode 120). In this case, the gap P2 exposes the first electrode 120 of neighbouring solar cells. The gap P2 is linearly formed in parallel with (e.g., is formed to extend parallel to) the gap P1.

Second electrodes 180 of neighbouring cells are separated by a separation groove P3. The separation groove P3 exposes the first electrode 120 (e.g., exposes a portion of the first electrode 120). In this case, the separation groove P3 exposes the first electrode 120 of neighbouring solar cells, and the width of the separation groove P3 may be in a range of about 20 $\mu$m to about 100 $\mu$m.

The second electrodes 180 may respectively have thicknesses different from each other depending on the amount of current to be generated in a solar cell. That is, the thickness of a second electrode 180 of a solar cell generating a relatively small amount of current is formed to be relatively thin so as to increase a transmission amount therethrough, and the thickness of a second electrode 180 of a solar cell generating a relatively large amount of current is formed to be relatively thick so as to reduce the transmission amount therethrough.

In this case, a solar cell including a first electrode 120 having a relatively large width further includes a second electrode that is thinner than a second electrode 180 of an other solar cell including a first electrode 120 that is relatively narrow (e.g., has a relatively small width).

The thickness of the second electrode 180 may be in a range of about 0.9 $\mu$m to about 1.25 $\mu$m.

Meanwhile, a correspondence between the width of the first electrode 120 and the thickness of the second electrode 180 (e.g., a relationship between the width of the first electrode 120 and the thickness of the second electrode 180) in each cell can be determined from Equation 1.

Equation 1:

$$Y = 1 + X1 * (1 + A * X2)$$

Herein, Y denotes a relative rate of a short-circuit current Jsc, X1 denotes a ratio of a change of widths of different first electrodes, X2 denotes a ratio of a change of widths of different second electrodes, and $-0.12 < A < -0.06$.

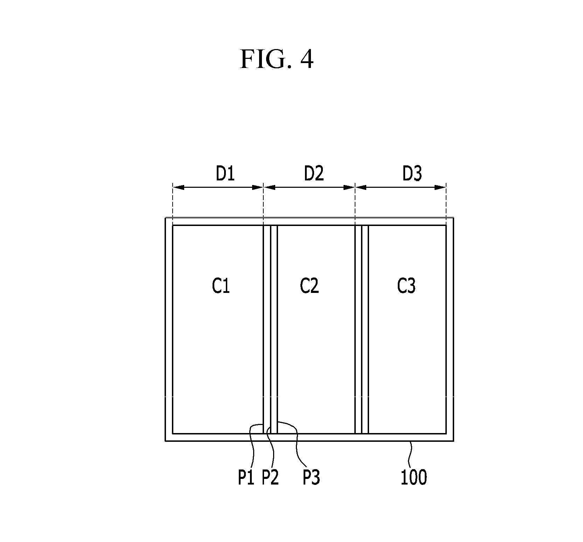

This will be further described with reference to FIG. 4.

A solar cell array shown in FIG. 4 includes a first cell C1, a second cell C2, and a third cell C3 respectively having substantially the same or the same width. However, the amount of current generated in the first to third cells C1 to C3 are 1, 2, and 3, respectively, is different, that is, each cell generates a different amount of current.

However, it will be described hereinafter that the amount of current generated in each of the cells is made to be the same or substantially the same (e.g., made to be equivalent to) the amount of current generated in the second cell.

With reference to the second cell C2, Y of the first cell C1 with respect to the second cell C2 is 0.5. When the width of the first electrode is adjusted or varied without changing the thickness of the second electrode, X1 of the first cell C1 can be 0.5 from Equation 1. Because the amount of current generated in a cell is proportional to the width of the first electrode thereof, the width D1 of the first electrode of the first cell C1 is increased to have a ratio of 0.5 with respect to the width D2 of the first electrode of the second cell C2. That is, because the amount of current generated in the first cell C1 is less than the amount of current generated in the second cell C2 having substantially the same area, the width of the first electrode of the first cell C1 is increased to increase the amount of current generated in the first cell C1 so that it becomes the same or substantially the same as (e.g., equivalent to) the amount of current generated in the second cell C2.

In addition, because Y of the third cell C3 becomes 1.5 with reference to the second cell C2, X1 of the first cell C1 becomes 0.5 from Equation 1. The amount of current generated in a cell is proportional to the width of the first electrode thereof, and therefore, the width D3 of the first electrode of the third cell C3 is reduced to have a ratio of 0.5 with respect to the width D2 of the first electrode of the second cell C2. That is, the amount of current generated in the third cell C3 is greater than the amount of current generated in the second cell C2 having the same area, and therefore, the amount of current generated in the third cell C3 is reduced by reducing the width of the first electrode of the third cell C3 so as to make the amount of current generated in the third cell C3 equal to the amount of current generated in the second cell C2.

In addition, when the thickness of only the second electrode is adjusted without changing the width of the first electrode, X2 becomes 0.5/A of X from Equation 1. A is a constant that depends on transmittance and conductivity of the second electrode, and therefore, A may be in a range of -0.12<A<-0.06. When A is less than -0.12 or greater than -0.06, the transmittance and the conductivity of the second electrode are deteriorated, thereby causing current leakage.

Because the amount of current generated in a cell is inversely proportional to the thickness of the second electrode, the thickness of the second electrode of the first cell C1 generating a relatively small amount of current is decreased to have a ratio of 0.5/A to increase the amount of current generated therein, and the thickness of the second electrode of the third cell C3 generating a relatively large amount of current is reduced to have a ratio of 0.5/A to make the amount of current generated in each of the first to third cells C1 to C3 the same or substantially the same (e.g., to equalize the amount of current generated in each of the first to third cells C1 to C3).

The above description is based on the amount of current generated in the second cell C2 as an example, but the amount of current generated in the first cell and/or the amount of current generated in the third cell C3 may be a reference current in the described embodiments.

As in the described embodiments of the present invention, the amount of current generated in each cell of the solar cells can be made the same or substantially the same (e.g., can be made uniform or equalized) by changing or varying the width of the first electrode and/or the thickness of the second electrode according to the amount of current generated in each cell. The width of the first electrode and/or the thickness of the second electrode may be changed with reference to the amount of current measured in the fabrication of a previous substrate, for example the amount of current generated in the reference cell of a previous substrate. The generated current is measured and the fabrication process for the subsequent substrate is adjusted to achieve equivalent currents across all of the solar cells in the substrate being presently fabricated.

The second electrode 180 may be made of a material having high light transmittance and excellent electrical conductivity and, for example, may be formed as a single layer or a multilayer including indium tin oxide (ITO), indium zinc oxide (IZO), and/or zinc oxide (ZnO). The light transmittance of the second electrode 180 may be greater than about 80 %. In this case, the ZnO layer has a low resistance value by being doped with aluminum (Al) and/or boron (B).

When the second electrode 180 is formed as a multilayer, the ITO layer having an excellent electro-optical characteristic may be layered on the ZnO layer or an n-type ZnO layer having a low resistance value may be layered on an i-type undoped ZnO layer.

The second electrode 180 is an n-type semiconductor and forms a p-n junction with the photoactive layer 140, which is a p-type semiconductor.

While this disclosure has been described in connection with what are presently considered to be practical example embodiments, it is to be understood that the invention is not limited to the disclosed embodiments, but, on the contrary, is intended to cover various modifications and equivalent arrangements included within the scope of the appended claims.

**Claims**

1. A solar cell array comprising:

    a substrate (100);
    a plurality of first electrodes (120) on the substrate and separated from each other;
    a photoactive layer (140) on each of the plurality of first electrodes, the photoactive layer having a gap exposing a neighbouring one of the first electrodes; and
    a second electrode (180) on each of the photoactive layers, the second electrode being electrically connected to the neighbouring one of the first electrodes at the gap,
    wherein at least two of the plurality of first electrodes have sizes different from each other.

2. The solar cell array of claim 1, wherein a difference between respective areas of the at least two first electrodes is within 3%.

3. The solar cell array of claim 2, wherein each of the plurality of first electrodes has a rectangular shape having a pair of short sides extending in a direction that crosses the gap, and lengths of the short sides of the respective first electrodes are different from each other.

4. The solar cell array of claim 3, wherein the length of each of the short sides of each of the plurality of first electrodes is in the range of 3.5 mm to 6 mm.

5. The solar cell array of any one of the preceding claims, wherein the second electrodes have thicknesses that are different from each other.

6. The solar cell array of claim 5, wherein a thickness of a second electrode on one of the first electrodes having a relatively large area is less than a thickness of a second electrode on another of the first electrodes having a relatively small area.

7. A solar cell array comprising:

a substrate;
a plurality of first electrodes on the substrate and separated from each other;
a photoactive layer on each of the plurality of first electrodes, the photoactive layer having a gap exposing a neighbouring one of the first electrodes; and
a second electrode on each of the photoactive layers, the second electrode being electrically coupled to the neighbouring one of the first electrodes at the gap,
wherein at least two of the second electrodes have thicknesses that are different from each other.

8. The solar cell array of claim 7, wherein a difference between thicknesses of the at least two second electrodes is within 3%.

9. The solar cell array of claim 7, wherein the thickness of each second electrode is in a range of 0.9 $\mu$m to 1.25 $\mu$m.

10. The solar cell array of claim 7, 8 or 9 wherein each of the first electrodes comprises an opaque metal, and the second electrode comprises a transparent conductive material.

11. The solar cell array of claim 10, wherein the photoactive layer comprises a CIGS-based material.

12. A method of manufacturing a solar cell array that comprises a plurality of solar cells, each of the solar cells comprising:

a first electrode (120);
a photoactive layer (140) on the first electrode extending to the first electrode of the neighbouring solar cell, the photoactive layer having a gap exposing the first electrode of the neighbouring solar cell; and
a second electrode (180) on the photoactive layer, the second electrode being electrically connected to the first electrode of the neighbouring solar cell at the gap,
the method comprising:

varying the size of the first electrodes and/or the thickness of the second electrodes of one or more of the solar cells so that the currents generated in each of the solar cells are substantially the same as one another.

13. The method of claim 12, comprising varying the size of the first electrodes and/or the thickness of the second electrodes based on information about currents generated by cells at a predetermined location on the substrate.

14. The method of claim 12 or 13, comprising:

fabricating a first solar cell array on a first substrate;
determining currents generated by solar cells in the first solar array;
adjusting the fabrication process to vary the size of the first electrodes and/or the thickness of the second electrodes to be fabricated as a second solar cell array on a second substrate; and
fabricating the second solar cell array on the second substrate using the adjusted fabrication process.

FIG. 1

## FIG. 2

FIG. 3

FIG. 4

Europäisches
Patentamt

European
Patent Office

Office européen
des brevets

# EUROPEAN SEARCH REPORT

Application Number

EP 14 18 7983

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/216886 A1 (IWAKURA TADASHI [JP]) 11 September 2008 (2008-09-11) * abstract; figures 1-5 * * paragraph [0010] * * paragraph [0031] - paragraph [0032] * | 1-6, 12-14 | INV. H01L31/046 |
| X | KR 2010 0133623 A (LG INNOTEK CO LTD [KR]) 22 December 2010 (2010-12-22) * abstract; figures 1-4 * * paragraph [0026] - paragraph [0031] * * paragraph [0061] - paragraph [0064] * * paragraph [0069] * | 1-14 | |
| X | US 2011/061706 A1 (PARK CHANG KYUN [KR] ET AL) 17 March 2011 (2011-03-17) * abstract; figures 1A-11B * * paragraph [0046] - paragraph [0048] * * paragraph [0115] * * claim 2 * | 1,2,12 | |
| X | US 2011/100414 A1 (MOON TAEHO [KR] ET AL) 5 May 2011 (2011-05-05) * abstract; figures 9-15 * * paragraph [0107] - paragraph [0115] * | 1,12 | TECHNICAL FIELDS SEARCHED (IPC) H01L |
| X | JP S62 66684 A (SANYO ELECTRIC CO) 26 March 1987 (1987-03-26) * abstract; figure 3 * | 1,12 | |
| X | JP 2005 302819 A (TOYOTA MOTOR CORP) 27 October 2005 (2005-10-27) * abstract; figure 1 * * paragraph [0021] * | 1,12 | |
| X | US 2008/121264 A1 (CHEN CHI-LIN [TW] ET AL) 29 May 2008 (2008-05-29) * abstract; figure 2 * * paragraph [0019] - paragraph [0026] * | 1,12 | |

-/--

The present search report has been drawn up for all claims

| Place of search | Date of completion of the search | Examiner |
|---|---|---|
| Berlin | 18 March 2015 | Favre, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

| | Europäisches Patentamt<br>European Patent Office<br>Office européen des brevets | **EUROPEAN SEARCH REPORT** | Application Number<br>EP 14 18 7983 |

### DOCUMENTS CONSIDERED TO BE RELEVANT

| Category | Citation of document with indication, where appropriate,<br>of relevant passages | Relevant<br>to claim | CLASSIFICATION OF THE<br>APPLICATION (IPC) |
|----------|----------------------------------------------------------------------------------|---------------------|---------------------------------------------|
| X | US 2008/083448 A1 (BORDEN PETER G [US])<br>10 April 2008 (2008-04-10)<br>* abstract; figure 2 *<br>* paragraph [0071] *<br>----- | 1,12 | |

TECHNICAL FIELDS
SEARCHED (IPC)

The present search report has been drawn up for all claims

| Place of search | Date of completion of the search | Examiner |
|-----------------|----------------------------------|----------|
| Berlin | 18 March 2015 | Favre, Pierre |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

........................................................................................................
& : member of the same patent family, corresponding
   document

EPO FORM 1503 03.82 (P04C01)

**ANNEX TO THE EUROPEAN SEARCH REPORT
ON EUROPEAN PATENT APPLICATION NO.**

EP 14 18 7983

This annex lists the patent family members relating to the patent documents cited in the above-mentioned European search report.
The members are as contained in the European Patent Office EDP file on
The European Patent Office is in no way liable for these particulars which are merely given for the purpose of information.

18-03-2015

| Patent document cited in search report | Publication date | Patent family member(s) | Publication date |
|---|---|---|---|
| US 2008216886 A1 | 11-09-2008 | CN 101213673 A<br>DE 112006001752 T5<br>JP 2007012976 A<br>US 2008216886 A1<br>WO 2007004501 A1 | 02-07-2008<br>29-05-2008<br>18-01-2007<br>11-09-2008<br>11-01-2007 |
| KR 20100133623 A | 22-12-2010 | NONE | |
| US 2011061706 A1 | 17-03-2011 | CN 102024826 A<br>DE 102009058794 A1<br>KR 20110029585 A<br>TW 201112426 A<br>US 2011061706 A1 | 20-04-2011<br>17-03-2011<br>23-03-2011<br>01-04-2011<br>17-03-2011 |
| US 2011100414 A1 | 05-05-2011 | EP 2494610 A2<br>KR 20110047440 A<br>US 2011100414 A1<br>WO 2011053006 A2 | 05-09-2012<br>09-05-2011<br>05-05-2011<br>05-05-2011 |
| JP S6266684 A | 26-03-1987 | JP H0528513 B2<br>JP S6266684 A | 26-04-1993<br>26-03-1987 |
| JP 2005302819 A | 27-10-2005 | NONE | |
| US 2008121264 A1 | 29-05-2008 | CN 101192617 A<br>TW 200824137 A<br>US 2008121264 A1 | 04-06-2008<br>01-06-2008<br>29-05-2008 |
| US 2008083448 A1 | 10-04-2008 | DE 112007002316 T5<br>JP 2010505282 A<br>TW 200828608 A<br>US 2008083448 A1<br>WO 2008042682 A2 | 26-11-2009<br>18-02-2010<br>01-07-2008<br>10-04-2008<br>10-04-2008 |

EPO FORM P0459